Europäisches Patentamt

(19) European Patent Office

Office européen des brevets

(11) Numéro de publication: **0 004 800**
**B1**

(12) **FASCICULE DE BREVET EUROPEEN**

(45) Date de publication du fascicule du brevet: **08.09.82**

(51) Int. Cl.³: **G 02 B 5/172, H 01 L 31/02**

(21) Numéro de dépôt: **79400095.0**

(22) Date de dépôt: **15.02.79**

(54) Matrice pour convertisseur opto-électronique et convertisseur pour extrémité de câbles à fibres optiques.

(30) Priorité: **31.03.78 FR 7809487**

(43) Date de publication de la demande:
**17.10.79 Bulletin 79/21**

(45) Mention de la délivrance du brevet:
**08.09.82 Bulletin 82/36**

(84) Etats contractants désignés:
**BE CH DE GB IT**

(56) Documents cités:
**US - A - 3 963 920**

(73) Titulaire: **LIGNES TELEGRAPHIQUES ET TELEPHONIQUES L.T.T.**
**1, rue Charles Bourseul**
**F-78702 Conflans Ste Honorine (FR)**

(72) Inventeur: **Chiron, Bernard**
**L.T.T. 1, rue Charles Bourseul**
**F-78702 Conflans Ste Honorine (FR)**
Inventeur: **Foure, Jean-Louis**
**L.T.T. 1, rue Charles Bourseul**
**F-78702 Conflans Ste Honorine (FR)**
Inventeur: **de Vecchis, Michel**
**L.T.T. 1, rue Charles Bourseul**
**F-78702 Conflans Ste Honorine (FR)**

(74) Mandataire: **Guyot, Liliane et al,**
**Thomson-CSF SCPI 173, Boulevard Haussmann**
**F-75360 Paris Cedex 08 (FR)**

Courier Press, Leamington Spa, England.

## Matrice pour convertisseur opto-électronique et convertisseur pour extrémité de câble à fibres optiques

La présente invention concerne les télécommunications utilisant des fibres optiques comme véhicule de l'information et plus particulièrement les dispositifs de conversion opto-électroniques disposés aux extrémités des câble à fibres optiques.

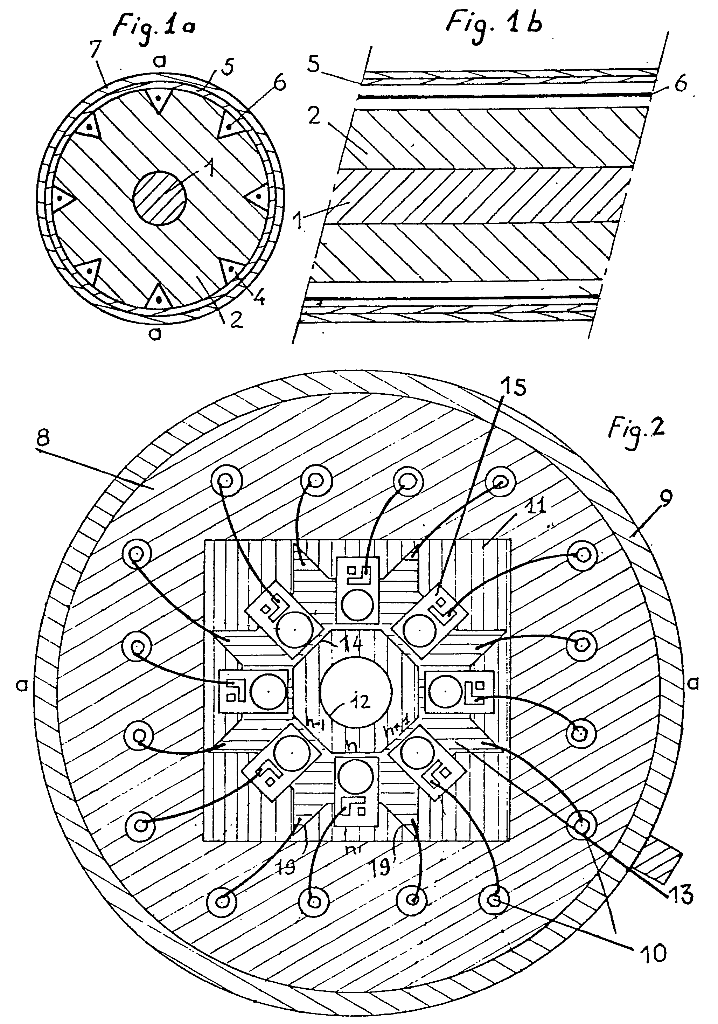

L'existence de câbles à plusiers fibres optiques indépendantes comme ceux décrits dans la demande de brevet français 2 419 524 déposée la 3 mars 1978 par la Demanderesse nécessite des dispositifs de conversion de signaux à accès multiples de façon à traiter simultanément les signaux véhiculés par chacune des fibres optiques du câble. Les figures 1a et 1b représentent respectivement les coupes transversale et longitudinale d'un élément de câble décrit dans le demande de brevet mentionnée. Il comporte une âme centrale 1 entourée d'un support diélectrique 2 présentant des rainures hélicoïdales 4 à profile en V extrudé sur une âme 1 mécaniquement rigide. Après la mise en place des fibres optiques 6 dans les rainures 4, un rubanage 5 referme les rainures tout en laissant aux fibres optiques 6 une liberté suffisante pour éviter les contraintes susceptibles de provoquer de l'atténuation. Lorsque le câble se limite à un élément, une gaine 7 le protège des agents extérieurs.

La présente invention se propose de fournir une matrice pour convertisseur de signaux, et un convertisseur particulièrement adapté à un câble du type qui vient d'être décrit.

On connaît de l'antériorité U.S. 3 963 920 une matrice destinée à un convertisseur opto-électronique pour extrémité de câble à fibres optiques, comprenant une embase munie d'un perçage et portant un substrat isolant comportant au moins un perçage, ledit substrat étant revêtu d'une métallisation.

L'invention concerne ainsi une matrice du type précité, caractérisé en ce que ladite embase et ledit substrat comportent chacun un perçage suivant le même axe, et en ce que ladite métallisation dudit substrat présente un contour intérieur en forme de polygône régulier convexe à n côtés admettant l'axe desdits perçages comme axe de symétrie et des emplacements pour positionner n composants opto-électroniques.

L'invention concerne également un convertisseur caractérisé en ce qu'il comporte une matrice du type précité et n composants opto-électroniques ayant chacun au moins une électrode reliée à la métallisation et une électrode reliée à un passage isolé de l'embase, lesdits composants étant montés sur ladite métallisation aux points d'intersection des prolongements de deux côtés adjacents aux même côté dudit polygône.

Le convertisseur selon l'invention présente les avantages suivants:

— lorsqu'il constitue un élément de connecteur, le raccordement ne nécessite pas d'opérations délicates, celles-ci ayant été effectuées préalablement en usine par des spécialistes disposant des moyens nécessaires compte tenu de la précision requise; la mise en place du convertisseur ne fait appel qu'à des techniques faciles à mettre en oeuvre sur le chantier:

— les dimensions des convertisseurs sont adaptées au diamètre du câble; cette caractéristique est particulièrement intéressante lorsque le câble est composé de plusieurs éléments du type représenté sur la figure 1;

— en cas de panne (rupture d'une fibre, mise hors service d'un dispositif opto-électronique) la matrice peut être remplacée sur le chantier sans intervention sur le câble;

— l'interface des convertisseurs avec l'extérieur est assurée à l'aide d'une embase de boîtier normalisé qu'il suffit d'enficher dans le support associé à l'équipement terminal.

Dans la variante où le convertisseur est directement associé aux deux extrémités de câble en usine, on obtient l'équivalent d'un cordon de conducteurs terminé par deux prises standard.

L'invention sera mieux comprise à l'aide de la description qui suit accompagnée des figures 1 à 7 données à titre d'illustration non limitative dans lesquelles:

— les figures la et 1b représentent deux coupes perpendiculaires d'un câble à fibres optiques auquel s'adapte le convertisseur de l'invention;

— les figures 2 et 3 représentent deux vues de dessus de convertisseurs pourvus de matrices de conversion, l'un de réception, l'autre d'émission;

— la figure 4 représente la coupe d'un convertisseur;

— la figure 5 représente la coupe d'une mise en oeuvre d'un convertisseur selon l'invention;

— la figure 6 représente le convertisseur de la figure 5 raccordé à l'extrémité d'un câble à fibres optiques;

— la figure 7 représente une seconde variante de convertisseur selon l'invention fixé sur un câble à fibres optiques.

Les figures 1a et 1b ont été commentées dans ce qui précède.

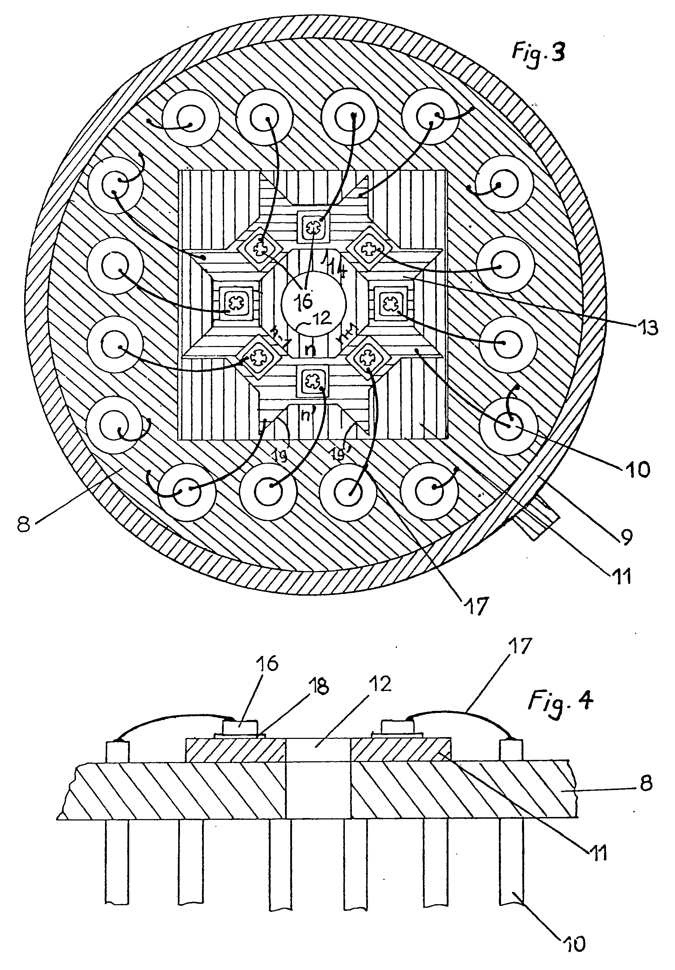

Les figures 2 et 3 représentent deux vues de dessus de matrices pour convertisseurs respectivement de réception et d'émission comportant une embase 8 associée à une bague métallique 9. L'embase 8 est un élément de boîtier normalisé pour semi-conducteur présentant le nombre de passages isolés 10 nécessaire à l'alimentation des composants opto-électroniques, tels les photodiodes 16, les phototransistors 15, utilisés. Un substrat 11, par exemple en alumine, de forme carrée, est collé sur l'embase 8 de façon que son centre de symétrie soit situé sur l'axe de symétrie de l'embase 8. Ce substrat présente un perçage 12 correspondant à un perçage axial de l'embase 8. Sa face libre porte une métallisation 13, par exemple en or, dont le degré de symétrie est fixé par le nombre de composants opto-électroniques 15—16 utilisés, c'est-à-dire par le nombre de fibres optiques du câble associé. Dans l'exemple choisi à titre d'illustration ce nombre est huit, étant bien entendu que cette valeur n'est nullement limitative. La forme de la métallisation est une étoile délimitée intérieurement par un polygone régulier 14 qui a un nombre de côtés égal au nombre de fibres optiques du câble. Le contour extérieur de la métallisation 13 est réalisé en appliquant successivement à chacun des côtés du polygone 14 la règle suivante: à un côté n de 14 correspond un côté n' du contour extérieur de la métallisation parallèle à n et les prolongements des côtés n—1 et n+1 se croisent au centre du composant opto-électronique associé et se prolongent de façon à définir un côté des branches adjacentes 19 et 19' de l'étoile situées de part et d'autre de n'.

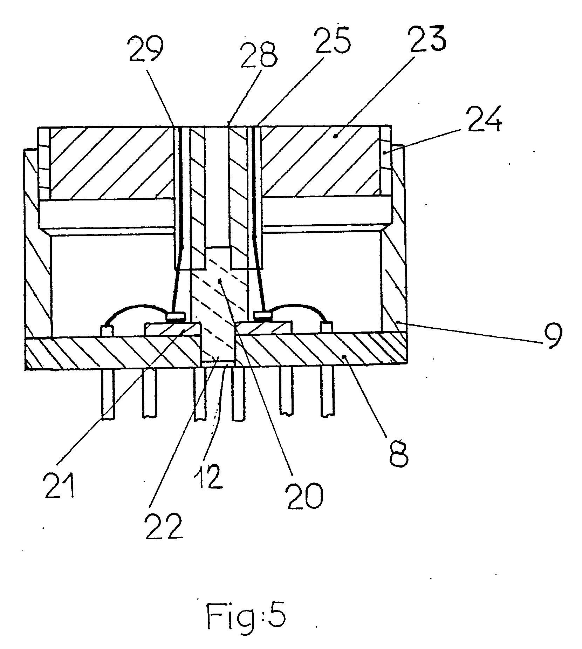

Cette forme est particulièrement avantageuse en ce qu'elle facilite le montage des composants 15 et 16 sur l'embase. En effet, l'existence physique des repères constitués par les côtés du polygone intérieur 14 permet le positionnement précis des composants par visée optique à partir d'une loupe binoculaire. Dans la variante de la figure 3 les composants opto-électroniques 16 sont des diodes photo-émissives en AsGa, l'embase côté réception étant représentée sur la figure 2 où les composants 15 sont des photo-transistors. La nature du composant opto-électronique 15—16 sur une embase est essentiellement définie par la nature de la liaison assurée par la fibre associée et des composants de nature différente peuvent être montés sur une même embase. Les composants 16 de l'embase de la figure 3 sont, par exemple, réalisés ainsi qu'il est décrit dans le brevet français 2 287 776 déposé par la Demanderesse le 9 octobre 1974. Ces composants photo-émissifs sont associés sur leur face non photosensible à une préforme en alliage AuGe qui permet une brasure sur la métallisation 13. Selon une variante préférée de l'invention, chacune des diodes est brasée sur une seconde préforme 18 du type Molytab avant brasure sur la métallisation. Les pastilles 18 permettent un contrôle individuel du bon fonctionnement de chacune des diodes avant montage. Des conducteurs 17 en or assurent les connexions nécessaires au fonctionnement du convertisseur entre les passages isolés 10, les composants 16 et la métallisation 13. Les liaisons sont assurées par thermocompression ainsi qu'il est d'usage. La figure 3 porte selon aa la trace du plan de la figure 4. La figure 2 représente une embase de réception sur laquelle les composants opto-électroniques sont des photo-transistors, toutefois ceux-ci peuvent être remplacés par des photo-diodes lorsqu'il est nécessaire d'élever la fréquence maximale de transmission. Les transistors utilisables sont du type LS400 (TI) lorsque les signaux transmis sur les fibres ont une fréquence inférieure à quelques 100 KHz et des diodes photosensibles du type HP4207 (HP) aux fréquences supérieures. Sur la figure 2, les bases des photo-transistors en liaison optique avec la fibre sont représentées par un cercle; leur potentiel est flottant. Les émetteurs sont reliés par les fils 17 aux broches de sortie 10 de l'embase. Les collecteurs sont maintenus par la métallisation 13 au potentiel de référence, ainsi qu'il est d'usage. La Figure 4 représente une coupe élévation d'une matrice composée de l'embase 8 et du substrat 11. La métallisation 13 n'est pas représentée sur le dessin. La plan de coupe choisi passe par deux pastilles 18 et par les composants 16 qu'elles portent, les fils 17 thermocompression les relient chacune à l'un des passages isolés 10. A titre d'exemple illustratif, non limitatif, la Demanderesse réalise le convertisseur de la figure 3 adapté à un câble de 6 millimètres de diamètre présentant un support diélectrique extrudé 2 de 4 millimètres de diamètre, comportant huit fibres optiques de 125 micromètres de diamètre, du type décrit dans la demande de brevet français 2 419 524 déposée par la Demanderesse le 8 mars 1978 pour "Eléments de câble à fibres optiques et câbles les incorporant". L'embase 8 utilisée pour la matrice est celle du boîtier normalisé F 136 à seize passages isolés. Le substrat 11 fixé sur l'embase a un côté de 7 millimètres; le perçage central 12 a un diamètre de 2 millimètres. La métallisation annulaire 13 est une dorure délimitée par un octogone intérieur 14 de 1,2 millimètre de côté. Le contour extérieur de la métallisation 13 est obtenu en menant des parallèles à 1,2 millimètre de chacun des côtés de l'octogone 14 et en prolongeant les côtés eux-mêmes ainsi qu'il a été indiqué dans ce qui précède. Les pastilles fixées sur la métallisation 13 ont une forme carrée ayant 0,73 millimètre de côté et une épaisseur de 0,5 millimètre. Ces pastilles portent une diode type TI XL06 (TI). La figure 5 représente la coupe longitudinale d'un convertisseur selon l'invention comportant un embout rigide 28, par exemple en céramique ou en matière plastique dure et un manchon en matière pastique souple 23, en "Silastène" par exemple, serti dans une bague métallique 24 présentant des dents à sommet plat pénétrant dans les rainures de l'embout. L'embout 28 présente des rainures 29 coopérant avec celles du câble, contenant chacune une fibre optique 25 collée sur la surface photosensible du composant associé et affleurée à ras de son extrémité libre. L'autre extrémité de l'embout de l'embout 28 est solidaire d'un téton de centrage 20 rapporté et collé présentant un épaulement 21 venant en butée sur le substrat 11 et un doigt de centrage 22 pénétrant à force dans le perçage 12. La bague 24 est immobilisée par collage sur la bague métallique 9. Lorsque l'assemblage de l'élément convertisseur est terminé, un capot de protection provisoire, non représenté sur la figure 5, coiffe la bague 9 afin de protéger l'extrémité libre de l'embout 28. A titre d'exemple illustratif, la Demanderesse réalise un convertisseur incorporant la matrice de conversion décrite dans ce qui précède de diamètre égal à 15 millimètres et de longueur depuis l'embase jusqu'à l'extrémité de l'embout supportant les fibres optiques égale à 18 millimètres.

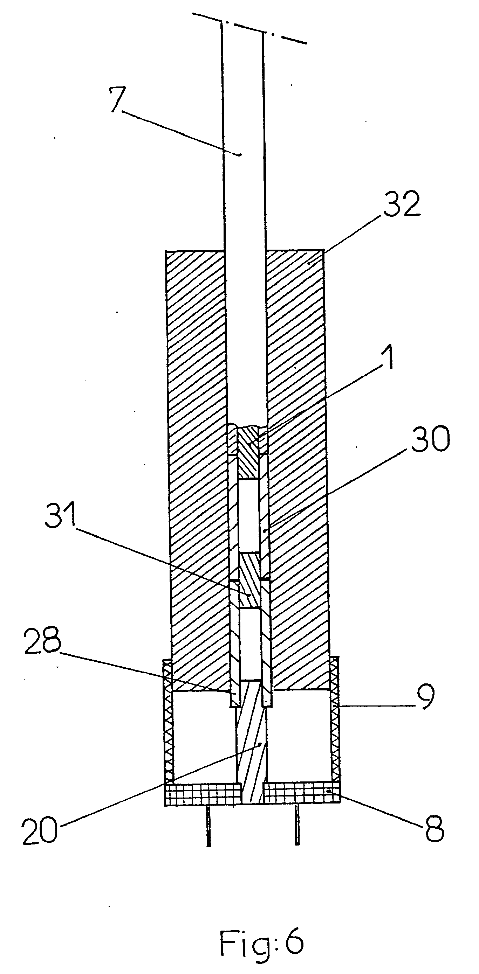

La figure 6 représente le raccordement d'un câble à un convertisseur selon l'invention.

L'extrémité du câble estaassociée à un raccord du type décrite dans le demande de brevet français 2 420 777 déposée le 24 mars 1978 par la Demanderesse pour "Procédé et appareillage de raccordement de câbles à fibres optiques". Pour simplifier le schéma, on a représenté en 32 l'ensemble des pièces mécaniques servant au serrage et comportant deux cônes de serrage associés à un manchon dont l'extrémité située du côté du convertisseur joue le rôle du manchon 23 de la variante de la figure 5. Le centrage de la matrice par rapport au câble est assuré comme suit. L'extrémité du câble est dénudée par élimination de la gaine 7 et du support 2 à fibres optiques et l'âme rigide 1 est centrée dans une pièce de prolongation 30 qui reproduit les rainures 4. Le diamètre de 30 est égal à celui de l'embout 28 centré par rapport à l'embase 8 de la matrice par le téton 20. A l'extrémité supérieure de 28 se trouve, partiellement introduite à force, une pièce de centrage cylindrique 31 qui pénètre, également à force, à la partie inférieure du prolongateur 30. Les fibres optiques du câble, non représentées, sont engagées dans les rainures du prolongateur 30 et de l'embout 28. Elles sont maintenues dans ces rainures par un ensemble de tiges d'alignement non représentées, ainsi qu'il est expliqué dans la demande citée ci-dessus. Le centrage du câble par rapport à l'embase est assuré par l'ensemble des éléments 20-28-31-30-1 et tiges d'alignement.

L'extrémité des fibres, après arasage, est fixée sur la surface photosensible des composants de la matrice, par exemple par collage. De bons résultats du point de vue de l'adaptation des indices ont été obtenus à l'aide de colle "Silastène" fabriquée par la Société Rhône-Poulenc.

A titre d'exemple illustratif, non limitatif, la Demanderesse réalise un raccordement incorporant le convertisseur selon l'invention de longueur totale égale à 40 millimètres et de diamètre maximal égal à 15 millimètres. Le convertisseur peut être associé ou dissocié du câble par des opérations simples à effectuer en chantier.

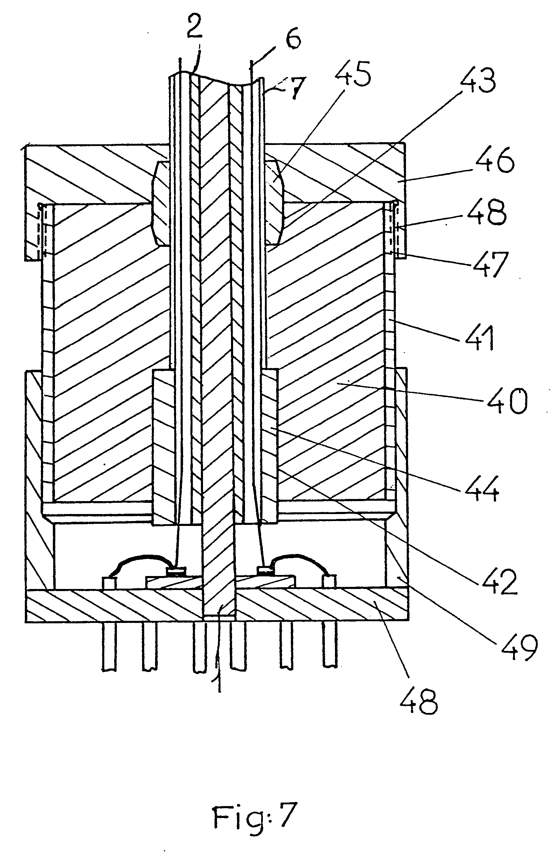

La figure 7 représente l'extrémité d'un câble à fibres optiques équipée d'un façon fixe d'un convertisseur selon l'invention. Le dispositif de fixation dudit convertisseur au niveau de l'extrémité du câble à fibres optiques est simplifié. Il comporte la bague métallique 49 de même diamètre et de même longueur que la bague 9 décrite dans ce qui précède et un manchon 40 en matière plastique serti dans un bague métallique 41 dont une extrémité entre à frottement gras dans la bague 49 et l'autre extrémité présente un filetage 47. Le manchon 40 présente à son extrémité tournée vers le convertisseur un logement cylindrique 42 ayant même axe que l'embase 48 et que l'extrémité dénudée 1 du câble qui pénètre dans l'ouverture centrale de l'embase ainsi qu'il a été expliqué plus haut. La bague 44 en maitère plastique souple en "Silastène" limitant les déplacements des fibres optiques 6 à ceux permis par les rainures 4 du câble occupe le logement 42. Elle porte sur sa face intérieure des dents reproduisant la forme des rainures dont le sommet est supprimé de façon à ménager un passage pour les fibres au fond de la rainure. L'extrémité du manchon 40 opposée au convertisseur présente une gorge 43 destinée à recevoir un joint 45 en matériau élastique, par exemple en "Silastène", entourant le câble et destiné à l'immobiliser dans le convertisseur lorsqu'il est comprimé par le serre-joint 46 dont le filetage 48 vient en prise sur 47. On effectue la mise en place lorsque les extrémités des fibres optiques ont été collées sur les zones photosensibles des composants photosensibles en amenant en position définitive la bague 44 et la bague métallique 41 contenant le manchon 40. La bague 41 est immobilisée par rapport à la bague 49, par exemple par collage, puis le joint 45 est introduit dans le logement 43 et serré à l'aide du serre-joint 46. Les différentes pièces ont été préalablement enfilées sur l'extrémité du câble ainsi qu'il est d'usage.

A titre d'exemple illustratif, non limitatif, la Demanderesse réalise un convertisseur pour le câble à huit fibres optiques déjà mentionné. Il présente une longueur égale à 12 millimètres de l'embase au serrejoint et un diamètre égal à 15 millimetres.

**Revendications**

1. Matrice pour convertisseur opto-électronique pour extrémité de câbles à fibres optiques comprenant une embase munie d'un perçage et portant un substrat isolant comportant au moins un perçage, ledit substrat étant revêtu d'une métallisation, caractérisée en ce que:

— ladite embase (8) et ledit substrat (11) comportent chacun un perçage (12) suivant le même axe,
— ladite métallisation (13) dudit substrat (11) présente un contour intérieur en forme de polygône régulier convexe (14) à n côtés admettant l'axe desdits perçages (12) comme axe de symétrie et des emplacements pour positionner n composants opto-électroniques.

2. Matrice selon la revendication 1, caractérisée en ce que le contour extérieur de ladite métallisation (13) est en forme d'étoile.

3. Convertisseur, caractérisé en ce qu'il comporte une matrice selon l'une des revendications 1 ou 2 et n composants opto-électroniques (15, 16) ayant chacun au moins une électrode reliée à la métallisation (13) et une électrode reliée à un passage isolé de l'embase, lesdits composants étant montés sur ladite métallisation aux points d'intersection des prolongements de deux côtés adjacents au même côté dudit polygône.

4. Convertisseur suivant la revendication 3, caractérisé en ce que lesdites composants sont montés sur la métallisation (13) par l'intermédiaire d'une pastille métallique conductrice (18)

5. Convertisseur suivant l'une des revendications 3 ou 4, caractérisé en ce qu'il comporte un embout (28) portant des rainures destinées à recevoir des fibres optiques et rendu solidaire desdits perçages de l'embase (8) et du substrat (11) par l'intermédiaire d'un téton de centrage (20).

6. Convertisseur suivant la revendication 5, caractérisé en ce qu'il comporte une bague 9 montée à la périphérie de l'embase et un manchon (23, 32) disposé entre la bague 9 et ledit embout (28), ledit manchon étant solidaire de la bague (9).

7. Convertisseur suivant l'une des revendications 5 ou 6, caractérisé en ce qu'il comporte une pièce de prolongation rainurée (30) disposée dans l'axe dudit manchon (28) et du côté opposé audit téton (20).

8. Convertisseur suivant l'une des revendications 3 ou 4, caractérisé en ce qu'il comporte une longueur de l'âme centrale (1) d'un câble à fibres optiques, qui pénètre dans lesdites perçages de ladite embase et dudit substrat, une bague (49) montée à la périphérie de l'embase, et un manchon (40) solidaire de la bague (49) et du support (2) dudit câble à fibres optiques.

9. Convertisseur suivant la revendication 8, caractérisé en ce qu'il comporte une bague souple (44) présentant sur sa face interne des dents à l'extrémité aplanie pénétrant dans les rainures du support (2).

### Patentansprüche

1. Matrize für optoelektronischen Umwandler für das Ende von Lichtleitkabeln, die einen Sockel mit einer Bohrung aufweist, welcher eine isolierende Grundlage mit wenigstens einer Bohrung trägt, wobei die genannte Grundlage mite einem Metallüberzug versehen ist, dadurch gekennzeichnet,

— dass der genannte Sockel (8) und die genannte Grundlage (11) je eine gleichachsige Bohrung (12) aufweisen;
— dass der genannte Metallüberzug (13) der genannten Grundlage (11) einen inneren Umfang in Form eines regelmässigen konvexen Vielecks (14) mit n Seiten aufweist, wobei die Achse der genannten Bohrungen (12) mit der Symmetrieachse des Vielecks übereinstimmt und das Vieleck Aufnahmeplätze zum Positionieren von n optoelektronischen Bauteilen freilässt.

2. Matrize nach Anspruch 1, dadurch gekennzeichnet, dass der äussere Umfang des genannten Metallüberzugs (13) sternförmig ist.

3. Umwandler, dadurch gekennzeichnet, dass er eine Matrize nach einem der Ansprüche 1 oder 2 sowie n optoelektronische Bauteile (15, 16) aufweist, die je wenigstens eine mit dem Metallüberzug (13) verbundene Elektrode und eine mit der isolierten Durchführung des Sockels verbundene Elektrode haben, wobei die genannten Bauteile auf dem genannten Metallüberzug an den Schnittstellen der Verlängerungen zweier benachbarter Seiten einer selben Seite des genannten Vielecks montiert sind.

4. Umwandler nach Anspruch 3, dadurch gekennzeichnet, dass die genannten Bauteile über ein leitendes Metallplättchen (18) auf dem Metallüberzug (13) montiert sind.

5. Umwandler nach einem der Ansprüche 3 oder 4, dadurch gekennzeichnet, das er ein Endstück (28) mit Rillen zur Aufnahme der Glasfasern aufweist, das über einen Zentrierbolzen (20) mit den genannten Bohrungen des Sockels (8) und der Grundlage (11) kraftschlüssig verbunden ist.

6. Umwandler nach Anspruch 5, dadurch gekennzeichnet, dass er am Umfang des Sockels einen Ring (9) sowie zwischen dem Ring (9) und dem genannten Endstück (28) eine Muffe (23, 32) aufweist, die mit dem Ring (9) kraftschlüssig verbunden ist.

7. Umwandler nach einem der Ansprüche 5 oder 6, dadurch gekennzeichnet, dass er ein gerilltes Verlängerungsteil (30) aufweist, das auf der Achse der genannten Muffe (28) und auf der dem genannten Zentrierbolzen (20) entgegengesetzten Seite liegt.

8. Umwandler nach einem der Ansprüche 3 oder 4, dadurch gekennzeichnet, das er eine Länge des zentralen Kerns (1) eines Lichtleiterkabels aufweist, die in den genannten Bohrungen des genannten Sockels und der genanten Grundlage eingeführt ist, einen Ring (49) am Umfang des Sockels sowie eine mit dem Ring (49) und dem Sockel (2) des genannten Lichtleitkabels kraftschlüssig verbundene Muffe (40) aufweist.

9. Umwandler nach Anspruch 8, dadurch gekennzeichnet, dass er einen geschmeidigen Ring (44) besitzt, der auf seiner inneren Seite Zähne mit abgeflachten Enden aufweist, die in die Rillen des Trägermaterials (2) eindringen.

## Claims

1. Matrix for opto-electronic converter for the ends of optical fiber cables, comprising a base provided with a bore-hole and bearing an insulating substrate having at least one bore-hole, the said substrate being metal coated, said matrix being characterized in that:

— the said base (8) and the said substrate (11) each comprise a bore-hole (12) along a single axis;
— the said metal coating (13) of the said substrate (11) has an inside contour in the form of a regular convex polygon (14) with n sides, the axis of symmetry of the said polygon being common to the axis of the said bore-holes (12), and has sites to position n opto-electronic components.

2. Matrix according to claim 1, characterized in that the outside contour of the said metal coating (13) is in the shape of a star.

3. Converter, characterized in that it comprises a matrix according to one of claims 1 or 2 and n opto-electronic components (15, 16) each having at least one electrode connected to the metal coating (13) and one electrode connected to an isolated passage of the base, the said components being fixed on the said metal coating at the points of intersection of the extensions of two adjacent sides on the same side of the said polygon.

4. Converter according to claim 3, characterized in that the said components are fixed on the metal coating (13) by the intermediary of a conductive metallic inset (18).

5. Converter according to one of claims 3 or 4, characterized in that it comprises a threaded end-fitting (28) having grooves designed to receive the optical fibers and integrally fixed to the said bore-holes of the base (8) and of the substrate (11) through the intermediary of a centering projection (20).

6. Converter according to claim 5, characterized in that it comprises a ring (9) mounted on the periphery of the base and an envelope (23, 32) positioned between the ring and the said threaded end-fitting, the said envelope being integral with the ring (9).

7. Converter according to one of claims 5 or 6, characterized in that it comprises a groove extension element (30) positioned along the axis of the said envelope (28) and on the side opposite the said projection (20).

8. Converter according to one of claims 3 or 4, characterized in that it comprises a length of the central core (1) of an optical fibers cable, that penetrates within said bore-holes of the said base and of the said substrate, a ring (49) mounted on the periphery of the base, and an envelope (40) integral with the ring (49) and with the support of the said optical fibers cable.

9. Converter according to claim 8, characterized in that it comprises a flexible ring (44), its inside face comprising teeth, the levelled ends of which penetrate within the grooves of the support (2).

0 004 800

Fig. 1a

Fig. 1b

Fig. 2

Fig. 3

13

10

9

11

17

8

16   18   12   17   Fig. 4

8

11

10

Fig:5

Fig:6

Fig. 7